# EUROPEAN PATENT APPLICATION

(11) **EP 2 048 209 A1**
(43) Date of publication of application: **15.04.2009**
(21) Application number: 07767396.0
(22) Date of filing: 22.06.2007
(51) Int. Cl.: C09J 4/00, C09J 129/14, C09J 133/00, C09J 167/00, C09J 171/10, C09J 175/04, C09J 179/08, H01B 1/22, H01L 21/60, H05K 1/03, H05K 3/32

(54) **ADHESIVE COMPOSITION, AND CONNECTION STRUCTURE FOR CIRCUIT MEMBER**

(30) Priority: 04.08.2006 JP 2006213235; 21.11.2006 JP 2006314620
(71) Applicant: Hitachi Chemical Company, Ltd., Tokyo 163-0449 (JP)
(72) Inventor: IZAWA, Hiroyuki c/o Hitachi Chemical Company Ltd.,, Tsukuba-shi Ibaraki 300-4247 (JP); SHIRASAKA, Toshiaki, Tsukuba-shi Ibaraki 300-4247 (JP); KUDOU, Sunao c/o Hitachi Chemical Company Ltd.,, Chikusei-shi Ibaraki 308-8524 (JP); TOMIZAWA, Keiko c/o Hitachi Chemical Company Ltd.,, Tsukuba-shi Ibaraki 300-4247 (JP); KATOGI, Shigeki c/o Hitachi Chemical Company Ltd.,, Tsukuba-shi Ibaraki 300-4247 (JP)
(74) Representative: Jönsson, Hans-Peter
(86) International application number: PCT/JP2007/062585
(87) International publication number: WO 2008/015852

(57) **Abstract**

The adhesive composition of the invention comprises (a) a thermoplastic resin, (b) a radical polymerizing compound with one or more fluorene structures in the molecule, and (c) a radical polymerization initiator.

## Description

### Technical Field

The present invention relates to an adhesive composition and a circuit member connection structure.

### Background Art

Semiconductor elements and liquid crystal display elements have traditionally employed various types of adhesives for bonding between the members in the elements. The adhesives must exhibit not only adhesion, but also heat resistance and reliability under high-temperature, high-humidity conditions. The adherends that are bonded include printed circuit boards and organic base materials such as polyimides, as well as metals such as copper and aluminum, and base materials with diverse surface conditions, such as ITO, SiNₓ, SiO₂ and the like. The adhesive must therefore have a molecular design suited for the adherend.

The conventional adhesives used for semiconductor elements and liquid crystal display elements have been thermosetting resins such as epoxy resins, which have excellent adhesive properties and high reliability (for example, see Patent document 1). The constituent components of such adhesives generally include an epoxy resin, a curing agent such as a phenol resin which is reactive with the epoxy resin, and a thermal latent catalyst that promotes reaction between the epoxy resin and curing agent. The thermal latent catalyst is an important factor determining the curing temperature and curing speed of the adhesive, and various compounds are selected from the viewpoint of their storage stability at room temperature and the curing speed with heating. In actual processes, such adhesives accomplish the desired bonding upon curing by heating at a temperature of 170-250°C for 1-3 hours.

However, with the increasingly higher integration of semiconductor elements and high definition of liquid crystal devices in recent years, interelement and interconnect pitches have become narrower to such a point that the heat of curing can adversely affect the peripheral members. Throughput must be improved for cost reduction, and therefore a demand exists for adhesion at lower temperatures for shorter time periods, i.e. "low-temperature fast curing". Methods exist for using low-activation-energy thermal latent catalysts in order to achieve such low-temperature fast curing, but it is notoriously very difficult for such methods to provide storage stability at near room temperature.

Increasing interest is recently being focused on radical curing adhesives, used with radical polymerizing compounds such as acrylate derivatives and methacrylate derivatives, and peroxides as radical polymerization initiators. Radical curing allows rapid curing due to the high reactivity of radical reactive species (see Patent document 2, for example). However, because radical curing adhesives undergo significant cure shrinkage during curing, the bonding strength is poorer than when epoxy resins are used. Methods for improving bonding strength have been proposed, such as methods of using urethane acrylate compounds as radical polymerizing compounds, with softness and pliability imparted by ether bonds (see Patent documents 3 and 4, for example).

[Patent document 1] Japanese Unexamined Patent Publication HEI No. 1-113480
[Patent document 2] Japanese Unexamined Patent Publication No. 2002-203427
[Patent document 3] Japanese Patent Publication No. 3522634
[Patent document 4] Japanese Unexamined Patent Publication No. 2002-285128

### Disclosure of the Invention

### Problems to be Solved by the Invention

It is known however that urethane acrylates, which have an ether bond in the molecule, lower the adhesive properties including the post-curing elastic modulus and glass transition temperature, while also increasing the absorption percentage and reducing the hydrolysis resistance. Consequently, when these are used as adhesives for semiconductor elements and liquid crystal display elements which must exhibit stable performance even after exposure to high-temperature, high-humidity conditions (for example, 85°C/85% RH) for prolonged periods (high-temperature, high-humidity testing), the physical properties such as adhesive force and connection resistance after reliability testing are impaired.

It is an object of the present invention, which has been accomplished in light of the aforementioned problems of the prior art, to provide an adhesive composition which exhibits excellent bonding strength and maintains stable performance (bonding strength and connection resistance) even after reliability testing (high-temperature, high-humidity testing), as well as a circuit member connection structure employing it.

### Means for Solving the Problems

In order to achieve the object stated above, the invention provides an adhesive composition comprising (a) a thermoplastic resin, (b) a radical polymerizing compound with one or more fluorene structures in the molecule, and (c) a radical polymerization initiator.

The adhesive composition of the invention is a radical curing adhesive composition comprising a radical polymerizing compound and a radical polymerization initiator. By containing the (b) radical polymerizing compound with one or more fluorene structures in the molecule as a radical polymerizing compound in the radical curing adhesive composition, the adhesive composition of the invention has reduced cure shrinkage and excellent bonding strength, while also exhibiting improved heat resistance when cured and thus maintaining superior properties even after reliability testing (high-temperature, high-humidity testing). In addition, the cured physical property (elastic modulus) is enhanced due to the rigid fluorene skeleton, thus resulting in improved reliability. Since the adhesive composition of the invention exhibits excellent bonding strength while maintaining stable performance even after reliability testing, it is therefore suitable for use as a circuit-connecting material.

The adhesive composition of the invention also preferably contains (d) a vinyl compound with one or more phosphate groups in the molecule. By containing the (d) vinyl compound with one or more phosphate groups in the molecule, the adhesive composition can exhibit excellent bonding strength for various types of base materials and especially metals.

In the adhesive composition of the invention, the (a) thermoplastic resin is preferably one containing at least one resin selected from the group consisting of phenoxy resins, polyester resins, polyurethane resins, polyester-urethane resins, butyral resins, acrylic resins and polyimide resins. By using these (a) thermoplastic resins, the adhesive composition will have improved heat resistance and adhesion, thus allowing more excellent bonding strength to be obtained, as well as improved cured heat resistance, thus allowing more excellent properties to be maintained even after reliability testing (high-temperature, high-humidity testing).

The adhesive composition of the invention also preferably contains (e) conductive particles. Including (e) conductive particles can impart conductivity or anisotropic conductivity to the adhesive composition, thereby allowing the adhesive composition to be suitably used for connection between circuit members with circuit electrodes.

The invention further provides a circuit member connection structure comprising a first circuit member having a first circuit electrode formed on the main side of a first circuit board, a second circuit member having a second circuit electrode formed on the main side of a second circuit board, and a circuit-connecting member formed between the main side of the first circuit board and the main side of the second circuit board, which connects the first and second circuit members with the first circuit electrode and second circuit electrode positioned facing each other, the circuit member connection structure being **characterized in that** the circuit-connecting member consists of the cured product of an adhesive composition according to the invention, and the mutually facing first circuit electrode and second circuit electrode are electrically connected.

In this circuit member connection structure, the first and second circuit members are connected by a circuit-connecting member composed of a cured adhesive composition of the invention, and therefore the bonding strength between circuit members is sufficiently high and stable performance (bonding strength and connection resistance) can be maintained even after reliability testing (high-temperature, high-humidity testing).

### Effect of the Invention

According to the invention it is possible to provide an adhesive composition that, as a radical curing composition, can exhibit excellent bonding strength and can maintain stable performance (bonding strength and connection resistance) even after reliability testing (for example, standing at 85°C/85% RH), as well as a circuit member connection structure employing it.

### Brief Description of the Drawings

Fig. 1 is a cross-sectional view showing an embodiment of an adhesive film composed of an adhesive composition of the invention.
Fig. 2 is a simplified cross-sectional view showing an embodiment of a circuit member connection structure according to the invention.
Fig. 3(a)-(c) are the process steps in order for connection of circuit members.

### Explanation of Symbols

1: Adhesive film, 5: adhesive component, 7: conductive particles, 10: circuit-connecting member, 11: insulating material, 20: first circuit member, 21: circuit board (first circuit board), 21a: main side, 22: circuit electrode (first circuit electrode), 30: second circuit member, 31: circuit board (second circuit board), 31a: main side, 32: circuit electrode (second circuit electrode), 40: circuit-connecting material film.

### Best Mode for Carrying Out the Invention

Preferred embodiments of the invention will now be explained in detail, with reference to the accompanying drawings as necessary. Identical or corresponding parts in the drawings will be referred to by like reference numerals and will be explained only once. The term "(meth)acrylic acid" used throughout the explanation that follows means acrylic acid and its corresponding methacrylic acid, (meth)acrylate means acrylate and its corresponding methacrylate, and (meth)acryloyl group means acryloyl and its corresponding methacryloyl group.

The adhesive composition of the invention is characterized by comprising (a) a thermoplastic resin, (b) a radical polymerizing compound with one or more fluorene structures in the molecule, and (c) a radical polymerization initiator.

The (a) thermoplastic resin used for the invention may be any known one without any particular restrictions, and examples thereof include polyimide, polyamide and phenoxy resins, poly(meth)acrylates, polyimides, polyurethanes, polyesters, polyester urethanes, polyvinyl butyrals and the like. From the viewpoint of bonding strength, the (a) thermoplastic resin is preferably at least one selected from the group consisting of phenoxy resins, polyester resins, polyurethane resins, polyester urethane resins, butyral resins, acrylic resins and polyimide resins. Any of these may be used alone or in mixtures of two or more. These resins may optionally have a siloxane bond or fluorine-substituted group in the molecule. When two or more of these thermoplastic resins are used in admixture, they may be resins that are fully miscible, or that exhibit microphase separation to an opaque state.

The adhesive composition of the invention will exhibit better film formability with a larger molecular weight of the (a) thermoplastic resin, while the melt viscosity, which affects the flow properties of the adhesive composition, may be set within a wide range. There are no particular restrictions on the molecular weight of the (a) thermoplastic resin, but generally a weight-average molecular weight of 5,000-150,000 is preferred, with 10,000-80,000 being more preferred. A molecular weight value of less than 5,000 will tend to result in inferior film formability, while a value of greater than 150,000 will tend to reduce the compatibility with other components.

The content of the (a) thermoplastic resin in the adhesive composition of the invention is preferably 10-80 mass% and more preferably 15-70 mass% based on the total mass of the adhesive composition. A content of less than 10 mass% will tend to lower the adhesion, while a proportion of greater than 80 mass% will tend to impair the resin flow property.

The (b) radical polymerizing compound used for the invention has one or more fluorene structures in the molecule. From the viewpoint of further improving the heat resistance and adhesion, the (b) radical polymerizing compound more preferably is a compound having in the molecule two or more of at least one group selected from among (meth)acryloyl, vinyl and allyl groups as radical-polymerizing groups.

As the (b) radical polymerizing compound there may be mentioned, specifically, bisphenoxyethanolfluorene acrylate, epoxy (meth)acrylate obtained by adding (meth)acrylic acid to the glycidyl group of bisphenolfluorenediglycidyl ether, compounds obtained by introducing a (meth)acryloyloxy group into a compound formed by adding ethylene glycol or propylene glycol to the glycidyl group of bisphenolfluorenediglycidyl ether, and compounds represented by the following general formulas (A) and (B). Preferred among these are compounds represented by the following general formula (A), as they allow more excellent bonding strength to be obtained and can more adequately maintain stable performance after reliability testing. Any of these compounds may be used alone or in mixtures of two or more.

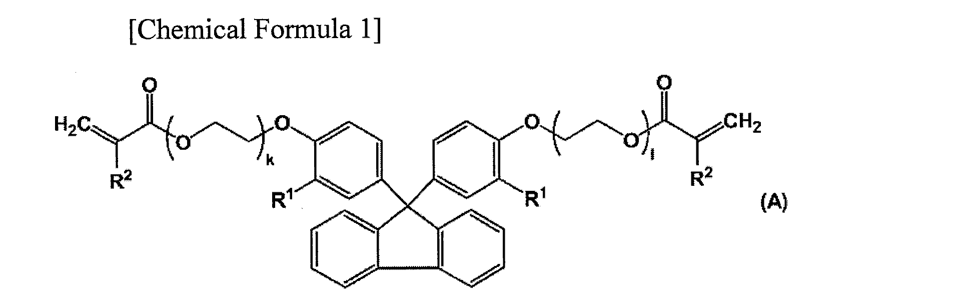

In formula (A), R¹ and R² each independently represent hydrogen or a methyl group, and k and 1 each independently represent an integer of 1-8. In formula (A), each R¹ and R² may be either the same or different. From the viewpoint of more satisfactorily obtaining an effect of rigidity by the fluorene structure, k and 1 each independently represent preferably an integer of not greater than 4 and more preferably an integer of not greater than 3.

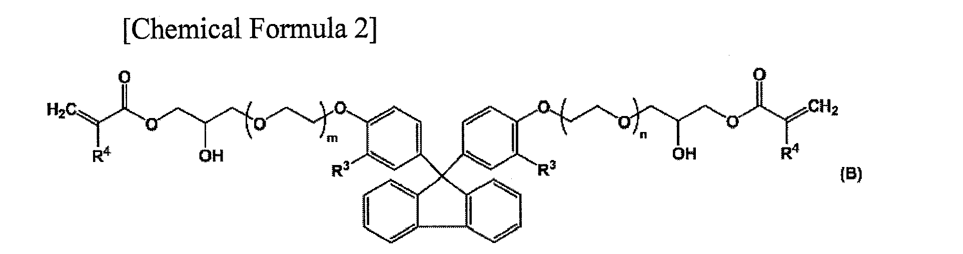

In formula (B), R³ and R⁴ each independently represent hydrogen or a methyl group, and m and n each independently represent an integer of 1-8. In formula (B), each R³ and R⁴ may be either the same or different. From the viewpoint of more satisfactorily obtaining an effect of rigidity by the fluorene structure, m and n each independently represent preferably an integer of not greater than 4 and more preferably an integer of not greater than 3.

The (b) radical polymerizing compound is more preferably a bifunctional compound such as a compound represented by general formula (A) or (B) above, rather than a tetrafunctional or other polyfunctional compound. Using a bifunctional compound such as a compound represented by general formula (A) or (B) rather than a tetrafunctional or other functional compound is effective for allowing suitable adjustment of the cured hardness and improving the adhesive force.

The content of the (b) radical polymerizing compound in the adhesive composition of the invention is preferably 30-250 parts by mass and more preferably 50-150 parts by mass with respect to 100 parts by mass of the (a) thermoplastic resin. If the content is less than 30 parts by mass the post-curing heat resistance may be lowered, and if it is greater than 250 parts by mass the film formability for use as a film may be reduced.

The (c) radical polymerization initiator used for the invention may be a publicly known peroxide or azo compound known in the prior art. From the viewpoint of obtaining satisfactory stability, reactivity and compatibility, the (c) radical polymerization initiator is preferably a peroxide with a one-minute half-life temperature of 90-175°C and a molecular weight of 180-1000. Here, a "one-minute half-life temperature" is the temperature at which the half-life is one minute, and the "half-life" is the time within which the compound concentration is reduced to half its initial value.

As specific (c) radical polymerization initiators there may be mentioned 1,1,3,3-tetramethylbutylperoxy neodecanoate, di(4-t-butylcyclohexyl)peroxy dicarbonate, di(2-ethylhexyl)peroxy dicarbonate, cumylperoxy neodecanoate, 1,1,3,3-tetramethylbutylperoxy neodecanoate, dilauroyl peroxide, 1-cyclohexyl-1-methylethylperoxy neodecanoate, t-hexylperoxy neodecanoate, t-butylperoxy neodecanoate, t-butylperoxy pivalate, 1,1,3,3-tetramethylbutylperoxy-2-ethyl hexanoate, 2,5-dimethyl-2,5-di(2-ethylhexanoylperoxy)hexane, t-hexylperoxy-2-ethyl hexanoate, t-butylperoxy-2-ethyl hexanoate, t-butylperoxy neoheptanoate, t-amylperoxy-2-ethyl hexanoate, di-t-butylperoxy hexahydroterephthalate, t-amylperoxy-3,5,5-trimethyl hexanoate, 3-hydroxy-1,1-dimethylbutylperoxy neodecanoate, 1,1,3,3-tetramethylbutylperoxy-2-ethyl hexanoate, t-amylperoxy neodecanoate, t-amylperoxy-2-ethyl hexanoate, di(3-methylbenzoyl)peroxide, dibenzoyl peroxide, di(4-methylbenzoyl)peroxide, 2,2'-azobis-2,4-dimethylvaleronitrile, 1,1'-azobis(1-acetoxy-1-phenylethane), 2,2'-azobisisobutyronitrile, 2,2'-azobis(2-methylbutyronitrile), dimethyl-2,2'-azobisisobutyronitrile, 4,4'-azobis(4-cyanovaleric acid), 1,1'-azobis(1-cyclohexanecarbonitrile), t-hexylperoxyisopropyl monocarbonate, t-butylperoxymaleic acid, t-butylperoxy-3,5,5-trimethyl hexanoate, t-butylperoxy laurate, 2,5-dimethyl-2,5-di(3-methylbenzoylperoxy)hexane, t-butylperoxy-2-ethylhexyl monocarbonate, t-hexyl peroxybenzoate, 2,5-dimethyl-2,5-di(benzoylperoxy)hexane, t-butyl peroxybenzoate, dibutyl peroxytrimethyladipate, t-amyl peroxy-n-octoate, t-amyl peroxyisononanoate and t-amyl peroxybenzoate. Any of these compounds may be used alone or in mixtures of two or more.

According to the invention, the (c) radical polymerization initiator may be a compound that generates radicals by photoirradiation at a wavelength of 150-750 nm. Such compounds may be any publicly known compounds without any particular restrictions. Preferred examples of (c) radical polymerization initiators that generate radicals by photoirradiation at a wavelength of 150-750 nm include the α-acetoaminophenone derivatives and phosphine oxide derivatives described in "Photoinitiation, Photopolymerization, and Photocuring", J.P. Fouassier, Hanser Publishers (1995), p17-p35, because of their high sensitivity to photoirradiation. These compounds may be used alone, or two or more different compounds may be used in admixture or in combination with the aforementioned peroxides or azo compounds.

The content of the (c) radical polymerization initiator in the adhesive composition of the invention is preferably 0.1-50 parts by mass and more preferably 1-30 parts by mass with respect to 100 parts by mass of the (a) thermoplastic resin. If the content is less than 0.1 part by mass the curing may be insufficient, and if it is greater than 50 parts by mass the shelf stability may be reduced.

As (d) vinyl compounds with one or more phosphate groups in the molecule, which are used as necessary according to the invention, there may be used any known compounds without any particular restrictions, although compounds represented by the following general formulas (1)-(3) are preferred. The term "vinyl compound" according to the invention also includes compounds with methacryloyl groups.

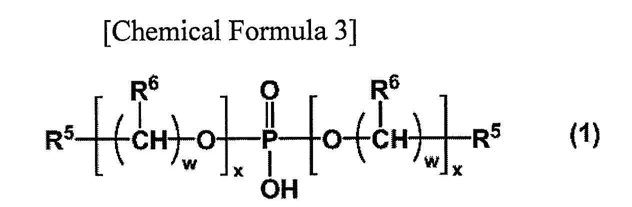

[In formula (1), R⁵ represents a (meth)acryloyl group, R⁶ represents hydrogen or a methyl group, and w and x each independently represent an integer of 1-8. In formula (1), each R⁵, R⁶, w and x may be either the same or different.]

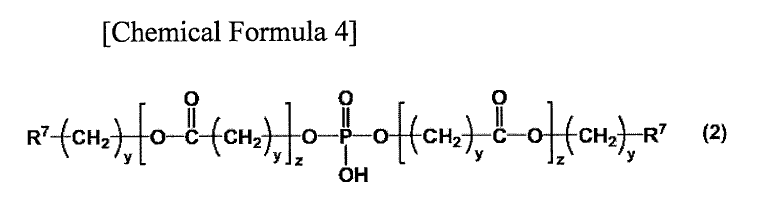

[In formula (2), R⁷ represents a (meth)acryloyl group, and y and z each independently represent an integer of 1-8. In formula (2), each R⁷, y and z may be either the same or different.]

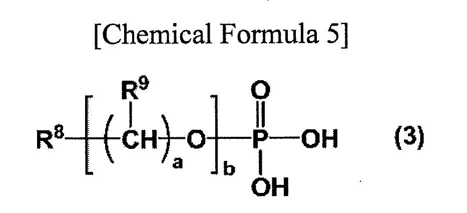

[In formula (3), R⁸ represents a (meth)acryloyl group, R⁹ represents hydrogen or a methyl group, and a and b each independently represent an integer of 1-8. In formula (3), each R⁹ and a may be either the same or different.]

As (d) vinyl compounds with one or more phosphate groups in the molecule there may be mentioned, more specifically, acid phosphooxyethyl methacrylate, acid phosphooxyethyl acrylate, acid phosphooxypropyl methacrylate, acid phosphooxypolyoxyethyleneglycol monomethacrylate, acid phosphooxypolyoxypropyleneglycol monomethacrylate, 2,2'-di(meth)acryloyloxydiethyl phosphate, EO-modified phosphoric acid dimethacrylate, phosphoric acid-modified epoxy acrylate and vinyl phosphate.

The content of the (d) vinyl compound with one or more phosphate groups in the molecule in the adhesive composition of the invention is preferably 0.1-15 parts by mass and more preferably 0.5-10 parts by mass with respect to 50 parts by mass of the (a) thermoplastic resin. If the content is less than 0.1 part by mass it will be more difficult to obtain high bonding strength, while if it is greater than 15 parts by mass, the physical properties of the cured adhesive composition will tend to be reduced and the reliability may be impaired.

The (e) conductive particles used as necessary for the invention may be metallic particles of Au, Ag, Ni, Cu, solder or the like, or carbon particles. Alternatively, the (e) conductive particles may have non-conductive glass, ceramic, plastic or the like as a core covered with the aforementioned metals or metallic particles, carbon or the like. When the (e) conductive particles have a plastic nucleus and are covered with the aforementioned metal or metallic particles or carbon, or when they are heat-fusible metallic particles, they will be deformable by heated pressure, so that when used to connect circuit members together the contact area between the conductive particles and electrodes will be increased, thereby improving the reliability. Fine particles having the surfaces of the conductive particles further covered with a polymer resin or the like will prevent shorting that occurs by contact between particles when the conductive particle content is increased, and will thus improve the insulating property between circuit electrodes. Particles having the conductive particle surfaces covered with a polymer resin may be used alone or in combination with other conductive particles.

The mean particle size of the (e) conductive particles is preferably 1-18 µm from the viewpoint of achieving satisfactory dispersibility and conductivity.

The content of the (e) conductive particles in the adhesive composition of the invention is not particularly restricted, but it is preferably 0.1-30 vol% and more preferably 0.1-10 vol% based on the total volume of the adhesive composition. If the content is less than 0.1 vol% the conductivity may be impaired, and if it is greater than 30 vol% there will be a greater tendency toward shorting between circuit electrodes. The content (vol%) of the (e) conductive particles is determined by the volume of each component before curing at 23°C. The volume of each component can be determined by utilizing the specific gravity for conversion from mass to volume. It may also be determined by placing an appropriate solvent (water, alcohol or the like), which is capable of thoroughly wetting the component whose volume is to measured without dissolving or swelling the component, in a graduated cylinder, introducing the component to be measured, and determining the increase in volume as the volume of the component.

The adhesive composition of the invention may also contain a radical polymerizing compound together with the (b) radical polymerizing compound having one or more fluorene structures in the molecule. As other radical polymerizing compounds there may be used any known compounds that polymerize by radicals, such as styrene derivatives or maleimide derivatives, without any particular restrictions.

As such specific radical polymerizing compounds there may be mentioned oligomers such as epoxy (meth)acrylate oligomers, polyether (meth)acrylate oligomers and polyester (meth)acrylate oligomers, as well as polyfunctional (meth)acrylate compounds such as trimethylolpropane tri(meth)acrylate, polyethyleneglycol di(meth)acrylate, polyalkyleneglycol di(meth)acrylate, dicyclopentenyl (meth)acrylate, dicyclopentenyloxyethyl (meth)acrylate, neopentyl glycol di(meth)acrylate, dipentaerythritol hexa(meth)acrylate, isocyanuric acid-modified bifunctional (meth)acrylates and isocyanuric acid-modified trifunctional (meth)acrylates.

Monofunctional (meth)acrylates may also be used to adjust the flow property of the adhesive composition. As examples of monofunctional (meth)acrylates there may be mentioned pentaerythritol (meth)acrylate, 2-cyanoethyl (meth)acrylate, cyclohexyl (meth)acrylate, dicyclopentenyl (meth)acrylate, dicyclopentenyloxyethyl (meth)acrylate, 2-(2-ethoxyethoxy)ethyl (meth)acrylate, 2-ethoxyethyl (meth)acrylate, 2-ethylhexyl (meth)acrylate, n-hexyl (meth)acrylate, 2-hydroxyethyl (meth)acrylate, hydroxypropyl (meth)acrylate, isobornyl (meth)acrylate, isodecyl (meth)acrylate, isooctyl (meth)acrylate, n-lauryl (meth)acrylate, 2-methoxyethyl (meth)acrylate, 2-phenoxyethyl (meth)acrylate, tetrahydrofurfuryl (meth)acrylate, 2-(meth)acryloyloxyethyl phosphate, N,N-dimethylaminoethyl (meth)acrylate, N,N-dimethylaminoethyl (meth)acrylate, N,N-dimethylaminopropyl (meth)acrylate, N,N-dimethylaminopropyl (meth)acrylate, (meth)acryloylmorpholine and the like. These compounds may be used alone, or if necessary multiple such compounds may be used in combination.

In order to improve the crosslinking rate, compounds with functional groups that polymerize by active radicals, such as allyl, maleimide and vinyl, may also be added as appropriate to the adhesive composition of the invention in addition to the aforementioned compound with a (meth)acryloyl group. As specific compounds there may be mentioned N-vinylimidazole, N-vinylpyridine, N-vinylpyrrolidone, N-vinylformamide, N-vinylcaprolactam, 4,4'-vinylidenebis(N,N-dimethylaniline), N-vinylacetamide, N,N-dimethylacrylamide, N-isopropylacrylamide and N,N-diethylacrylamide.

A stabilizer may also be added to the adhesive composition of the invention in order to control the curing speed and impart storage stability. Any known stabilizers may be used without any particular restrictions, although quinone derivatives such as benzoquinone and hydroquinone, phenol derivatives such as 4-methoxyphenol and 4-t-butylcatechol, aminoxyl derivatives such as 2,2,6,6-tetramethylpiperidine-1-oxyl and 4-hydroxy-2,2,6,6-tetramethylpiperidine-1-oxyl, and hindered amine derivatives such as tetramethylpiperidyl methacrylate are preferred.

The amount of stabilizer added is preferably 0.01-30 parts by mass and more preferably 0.05-10 parts by mass with respect to 100 parts by mass of the (a) thermoplastic resin. If it is added at less than 0.01 part by mass the effect of addition will tend to be insufficient, and if it is added at greater than 30 parts by mass the compatibility with other components may be reduced.

The adhesive composition of the invention may also contain added coupling agents such as alkoxysilane derivatives or silazane derivatives, or adhesion aids such as adhesion enhancers and leveling agents, as appropriate. Specifically, compounds represented by the following general formula (4) are preferred as adhesion aids. These adhesion enhancers may be used alone or in mixtures of two or more.

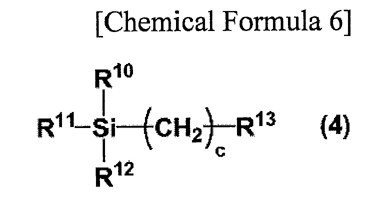

[In formula (4), R¹⁰, R¹¹ and R¹² each independently represent hydrogen, C1-5 alkyl, C1-5 alkoxy, C1-5 alkoxycarbonyl or aryl, R¹³ represents (meth)acryloyl, vinyl, isocyanato, imidazole, mercapto, amino, methylamino, dimethylamino, benzylamino, phenylamino, cyclohexylamino, morpholino, piperazino, ureido or glycidyl, and c represents an integer of 1-10.]

A rubber component may also be added to the adhesive composition of the invention for stress relaxation and improved adhesion. As specific rubber components there may be mentioned polyisoprene, polybutadiene, carboxyl-terminated polybutadiene, hydroxy-terminated polybutadiene, 1,2-polybutadiene, carboxyl-terminated 1,2-polybutadiene, hydroxy-terminated 1,2-polybutadiene, acrylic rubber, styrene-butadiene rubber, hydroxy-terminated styrene-butadiene rubber, acrylonitrile-butadiene rubber, acrylonitrile-butadiene rubber containing a carboxyl, hydroxyl, (meth)acryloyl or morpholine group at the polymer ends, carboxylated nitrile rubber, hydroxy-terminated poly(oxypropylene), alkoxysilyl-terminated poly(oxypropylene), poly(oxytetramethylene)glycol, polyolefin glycol and poly-ε-caprolactone.

From the viewpoint of enhancing adhesion, these rubber components are preferably rubber components containing highly polar groups such as cyano or carboxyl on a side chain or at the end, while from the viewpoint of improving the flow property they are even more preferably liquid rubber components. As specific rubber components there may be mentioned liquid acrylonitrile-butadiene rubber, liquid acrylonitrile-butadiene rubber containing a carboxyl, hydroxyl, (meth)acryloyl or morpholine group at the polymer ends, and liquid carboxylated nitrile rubber. The polar acrylonitrile content of these rubber components is preferably 10-60 mass%. Any of these compounds may be used alone or in mixtures of two or more.

The adhesive composition of the invention may be used in paste form if it is a liquid at room temperature (0-30°C). When it is a solid at room temperature (0-30°C), it may be heated or dissolved in a solvent to form a paste. The solvent used is not particularly restricted so long as it does not react with the adhesive composition (including its additives) and exhibits sufficient solubility for the adhesive composition, but it is preferably one with a boiling point of 50-150°C at ordinary pressure. If the boiling point is below 50°C, the solvent may volatilize when left out at room temperature (0-30°C), thus limiting its use in open systems. If the boiling point is above 150°C, it will be difficult to evaporate off the solvent and the reliability after adhesion may thus be adversely affected.

The adhesive composition of the invention may be shaped into a film for use as an adhesive film. When an adhesive film is formed, a solution obtained by adding a solvent to the adhesive composition as necessary may be coated onto a releasable base such as a fluorine resin film, polyethylene terephthalate film or release sheet, or a base material such as a nonwoven fabric may be impregnated with the solution and placed on a releasable base, and the solvent subsequently removed to obtain a film. The use of an adhesive film is even more convenient from the standpoint of manageability.

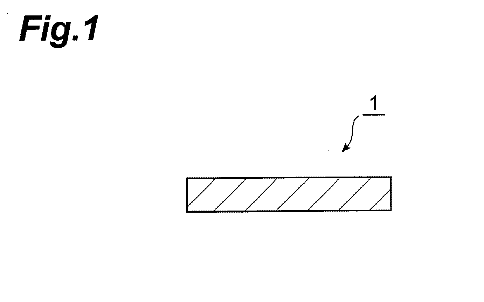

Fig. 1 is a cross-sectional view showing an embodiment of an adhesive film composed of an adhesive composition of the invention. The adhesive film 1 shown in Fig. 1 is obtained by forming a film from the adhesive composition. The adhesive film is manageable and may be easily placed on adherends to facilitate connection. The adhesive film 1 may also have a multilayer structure composed of two or more layers (not shown).

For most purposes, the adhesive composition and adhesive film of the invention may be bonded with the adherend by a combination of heating and pressurization. The heating temperature is not particularly restricted but is preferably a temperature of 100-250°C. The pressure is not particularly restricted so long as it is in a range that does not damage the adherend, and for most purposes it is preferably 0.1-10 MPa. The heating and pressurization are preferably carried out for a period in a range of 0.5-120 seconds. The adhesive composition and adhesive film of the invention are able to provide sufficient bonding between adherends even by, for example, heating and pressurization for a brief period of 10 seconds under conditions of 140-200°C, 3 MPa.

The adhesive composition and adhesive film of the invention may be used as an adhesive for adherends with different thermal expansion coefficients. Specifically, it may be used as a circuit-connecting material such as an anisotropic conductive adhesive, silver paste, silver film or the like, or as a semiconductor element adhesive material such as CSP elastomer, CSP underfill material, LOC tape or the like.

The following example illustrates the use of the adhesive composition and adhesive film of the invention as an anisotropic conductive adhesive composition and anisotropic conductive film for connection between circuit members having circuit electrodes formed on the main sides of circuit boards. Specifically, the anisotropic conductive adhesive composition or anisotropic conductive film may be placed between circuit electrodes facing each other on circuit boards and heated and pressed to accomplish electrical connection between the facing circuit electrodes and bonding between the circuit boards, for connection of the circuit members. The circuit boards on which the circuit electrodes are formed may be boards made of inorganic materials such as semiconductors, glass, ceramic or the like, boards made of organic materials such as polyimide or polycarbonate, or boards comprising a combination of inorganic and organic materials such as glass/epoxy. When an adhesive composition or adhesive film of the invention is used as a circuit-connecting material in this manner, it preferably also contains conductive particles.

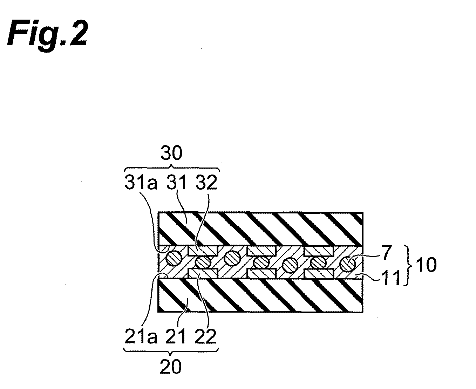

Fig. 2 is a simplified cross-sectional view showing an embodiment of a circuit member connection structure according to the invention. As shown in Fig. 2, the circuit member connection structure of this embodiment comprises a first circuit member 20 and a second circuit member 30 which are mutually opposing, and a circuit-connecting member 10 which is formed between the first circuit member 20 and second circuit member 30 and electrically connects them.

The first circuit member 20 comprises a circuit board (first circuit board) 21, and a circuit electrode (first circuit electrode) 22 formed on the main side 21 a of the circuit board 21. An insulating layer (not shown) may also be formed on the main side 21a of the circuit board 21.

The second circuit member 30 comprises a circuit board (second circuit board) 31, and a circuit electrode (second circuit electrode) 32 formed on the main side 31a of the circuit board 31. An insulating layer (not shown) may also be formed on the main side 31a of the circuit board 31.

The first and second circuit members 20, 30 are not particularly restricted so long as they contain the electrodes which require electrical connection. Specifically, there may be mentioned glass or plastic boards, printed circuit boards, ceramic circuit boards, flexible circuit boards, semiconductor silicon chips and the like on which electrodes are formed by ITO for use in liquid crystal display devices, and they may also be used in combination as necessary. According to this embodiment, therefore, it is possible to use printed circuit boards and circuit members with many and various surface forms including materials composed of organic materials such as polyimides, or inorganic materials which may be metals such as copper or aluminum, ITO (indium tin oxide), silicon nitride (SiNₓ), silicon dioxide (SiO₂) or the like.

The circuit-connecting member 10 is composed of an adhesive composition or a cured adhesive film according to the invention. The circuit-connecting member 10 comprises an insulating material 11 and conductive particles 7. The conductive particles 7 are situated not only between the opposing circuit electrode 22 and circuit electrode 32, but also between the main sides 21 a and 31a. In the circuit member connection structure, the circuit electrodes 22, 32 are electrically connected via the conductive particles 7. That is, the conductive particles 7 directly connect both the circuit electrodes 22 and 32.

The conductive particles 7 are the (e) conductive particles described above, and the insulating material 11 is the cured insulating component of each adhesive composition or adhesive film of the invention.

In this circuit member connection structure, the facing circuit electrode 22 and circuit electrode 32 are electrically connected via the conductive particles 7, as mentioned above. Connection resistance between the circuit electrodes 22, 32 is therefore sufficiently reduced. As a result, smooth current flow can be achieved between the circuit electrodes 22, 32 to allow the function of the circuit to be adequately exhibited. When the circuit-connecting member 10 does not contain conductive particles 7, the circuit electrode 22 and circuit electrode 32 are electrically connected by being in direct contact.

Since the circuit-connecting member 10 is composed of a cured adhesive composition or adhesive film of the invention, the bonding strength of the circuit-connecting member 10 for the circuit member 20 or 30 is sufficiently high and stable performance (bonding strength and connection resistance) can be maintained even after reliability testing (high-temperature, high-humidity testing).

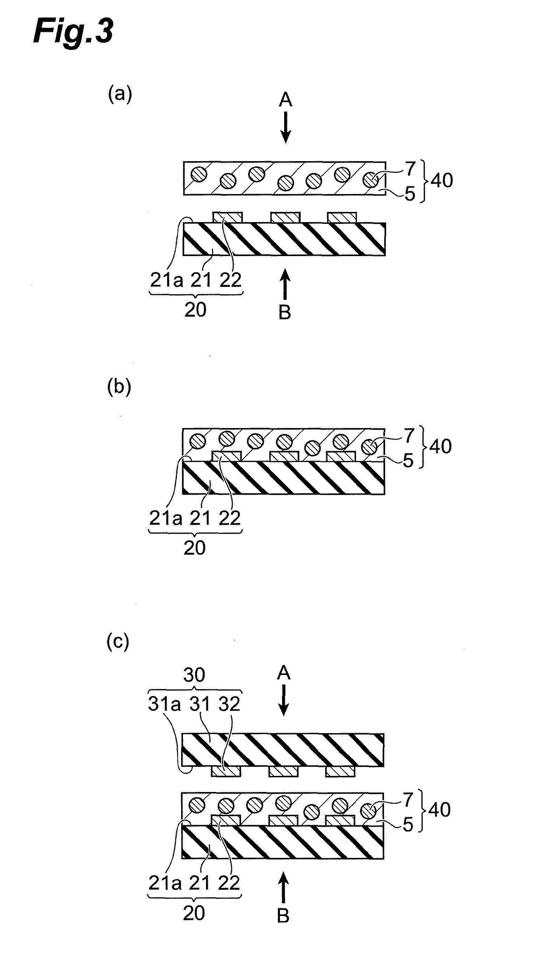

An example of a process for manufacturing the circuit member connection structure described above will now be explained. First, the first circuit member 20 and adhesive film (circuit-connecting material film) 40 are prepared (see Fig. 3(a)). The circuit-connecting material film 40 is obtained by forming the adhesive composition (circuit-connecting material) into a film, and it comprises the conductive particles 7 and adhesive component 5. When the circuit-connecting material does not contain conductive particles 7, the circuit-connecting material may be used as an insulating adhesive for anisotropic conductive bonding, in which case it is sometimes referred to as NCP (Non-Conductive Paste). When the circuit-connecting material contains conductive particles 7, the circuit-connecting material is sometimes referred to as ACP (Anisotropic Conductive Paste).

The thickness of the circuit-connecting material film 40 is preferably 10-50 µm. If the thickness of the circuit-connecting material film 40 is less than 10 µm, the circuit-connecting material may fail to sufficiently fill the area between the circuit electrodes 22, 32. If it is greater than 50 µm, on the other hand, the adhesive composition between the circuit electrodes 22, 32 will not be sufficiently eliminated between the circuit electrodes 22, 32.

The circuit-connecting material film 40 is then placed over the side of the first circuit member 20 on which the circuit electrode 22 has been formed. When the circuit-connecting material film 40 is attached onto a support (not shown), the circuit-connecting material film 40 is placed on the first circuit member 20 facing the first circuit member 20. The circuit-connecting material film 40 is easy to manage since it is in the form of a film. Thus, the circuit-connecting material film 40 may be easily situated between the first circuit member 20 and second circuit member 30 in order to facilitate the operation of connecting the first circuit member 20 and second circuit member 30.

The circuit-connecting material film 40 is pressed in the direction of the arrows A and B in Fig. 3(a) to provisionally join the circuit-connecting material film 40 with the first circuit member 20 (see (Fig. 3(b)). The pressing may be carried out with heating. However, the heating temperature must be a temperature at which the adhesive composition in the circuit-connecting material film 40 does not cure, i.e. at a lower temperature than the temperature at which the radical polymerization initiator generates radicals.

Next, as shown in Fig. 3(c), the second circuit member 30 is placed on the circuit-connecting material film 40 with the second circuit electrode facing the first circuit member 20. When the circuit-connecting material film 40 is attached onto a support (not shown), the second circuit member 30 is placed on the circuit-connecting material film 40 after releasing the support.

The circuit-connecting material film 40 is then pressed via the first and second circuit members 20, 30 in the direction of the arrows A and B in Fig. 3(c), while heating. The heating temperature is a temperature that allows radicals to be generated by the radical polymerization initiator. This will cause the radical polymerization initiator to generate radicals to initiate polymerization of the radical polymerizing compound. The circuit-connecting material film 40 is subjected to curing treatment for the main connection to obtain a circuit member connection structure as shown in Fig. 2.

The connecting conditions are preferably, as mentioned above, a heating temperature of 100-250°C, a pressure of 0.1-10 MPa and a connecting time of 0.5 seconds-120 seconds. The conditions for the procedure may be appropriately selected according to the purpose of use, the adhesive composition and the circuit member, and postcuring may also be performed if necessary.

By manufacturing a circuit member connection structure in the manner described above, it is possible to establish contact between both circuit electrodes 22, 32 facing the conductive particles 7 in the circuit member connection structure, and thereby adequately reduce connection resistance between the circuit electrodes 22, 32.

Heating of the circuit-connecting material film 40 hardens the adhesive component 5 with a sufficiently small distance between the first circuit electrode 22 and second circuit electrode 32, thus forming an insulating material 11 and firmly connecting the first circuit member 20 and second circuit member 30 via the circuit-connecting member 10. That is, since the circuit-connecting member 10 is composed of the cured circuit-connecting material containing the adhesive composition in the circuit member connection structure which is obtained, the bonding strength of the circuit-connecting member 10 for the circuit member 20 or 30 is sufficiently high and stable performance (bonding strength and connection resistance) can be maintained even after reliability testing (high-temperature, high-humidity testing).

Incidentally, although the adhesive component 5 used for this embodiment contains a radical polymerization initiator that generates radicals at least by heating, a radical polymerization initiator that generates radicals by photoirradiation alone may be used instead of this type of radical polymerization initiator. In this case, photoirradiation may be employed instead of heating for curing of the circuit-connecting material film 40. Also, while the circuit member connection structure of this embodiment was fabricated using the circuit-connecting material film 40, a circuit-connecting material that is not in the form of a film may be used instead of the circuit-connecting material film 40. In this case as well, dissolving the circuit-connecting material in a solvent and coating and drying the solution on either the first circuit member 20 or second circuit member 30 can form a circuit-connecting material between the first and second circuit members 20, 30.

Moreover, instead of a radical polymerization initiator that generates radicals by heat or photoirradiation, in the process for manufacturing a circuit member connection structure, a radical polymerization initiator that generates radicals by ultrasonic waves, electromagnetic waves or the like may be used as required.

### Examples

The present invention will now be explained in greater detail based on the following examples, with the understanding that the invention is in no way limited to the examples

### (Preparation of phenoxy resin solution)

A phenoxy resin solution with a solid content of 40 mass% was prepared by dissolving 40 parts by mass of a phenoxy resin (PKHM-30, trade name of InChem) in 60 parts by mass of methyl ethyl ketone.

### (Preparation of butyral resin solution)

A butyral resin solution with a solid content of 40 mass% was prepared by dissolving 40 parts by mass of a butyral resin (DENKA BUTYRAL 3000-1, trade name of Denki Kagaku Kogyo Co., Ltd.) in 60 parts by mass of methyl ethyl ketone.

### (Preparation of polyester-urethane resin solution)

UR-3210 (trade name of Toyobo, Ltd., solution in methyl ethyl ketone and toluene with a resin content of 30 mass%) was prepared as a polyester-urethane resin.

### (Synthesis of urethane resin)

In 4000 parts by mass of methyl ethyl ketone there were uniformly mixed 450 parts by mass of polybutylene adipate diol with a weight-average molecular weight of 2000 (product of Aldrich Co.), 450 parts by mass of polyoxytetramethylene glycol with a weight-average molecular weight of 2000 (product of Aldrich Co.) and 100 parts by mass of 1,4-butylene glycol (product of Aldrich Co.). After then adding 390 parts by mass of diphenylmethane diisocyanate (product of Aldrich Co.), the mixture was reacted at 50°C to obtain a urethane resin. The weight-average molecular weight of the obtained urethane resin was 100,000.

### (Preparation of radical polymerizing compounds)

There were prepared 9,9-bis(4-hydroxyphenyl)fluoreneethylene oxide-modified diacrylate (trade name: EA-0200 by Osaka Gas Co., Ltd., number of repeating EO chains (value of k+1 in formula (A)): 2, weight-average molecular weight: 546.61), 9,9-bis(4-hydroxyphenyl)fluoreneethylene oxide-modified diacrylate (trade name: EA-0500 by Osaka Gas Co., Ltd., number of repeating EO chains (value of k+1 in formula (A)): 5, weight-average molecular weight: 678.77), EO-modified bisphenol A diacrylate (trade name: FA-324A by Hitachi Chemical Co., Ltd.) and 2-(meth)acryloyloxyethyl phosphate (trade name: LIGHT ESTER P-2M by Kyoeisha Chemical Co., Ltd.).

### (Synthesis of urethane acrylate)

After introducing air into a reactor equipped with a stirrer, thermometer, condenser tube and air inlet tube, 238 parts by mass (2.05 mol) of 2-hydroxyethyl acrylate, 860 parts by mass (1 mol) of poly(hexamethylene carbonate)diol with a number-average molecular weight of 860 (product of Aldrich Co.), 0.53 part by mass of hydroquinone monomethyl ether and 5.53 parts by mass of dibutyltin dilaurate were charged therein and heated to 70-75°C, after which 666 parts by mass (3 mol) of isophorone diisocyanate was added dropwise thereto over a period of 3 hours for reaction. Reaction was terminated upon confirming disappearance of the isocyanate by IR, to obtain urethane acrylate (UA). The number-average molecular weight of the obtained urethane acrylate was 3700.

### (Preparation of radical polymerization initiator)

t-Hexylperoxy-2-ethyl hexanoate (trade name: PERHEXYL O, product of NOF Corp.) was prepared.

### (Formation of conductive particles)

A nickel layer with a thickness of 0.2 µm was formed on the surface of particles with polystyrene nuclei, and then a gold layer with a thickness of 0.02 µm was formed on the outside of the nickel layer. This produced conductive particles having a mean particle size of 4 µm and a specific gravity of 2.5.

### (Examples 1-6, Comparative Examples 1-3)

All of the aforementioned materials were combined in the proportions listed in Table 1 in terms of solid mass ratio, and then the conductive particles were added at 1.5 vol% (based on the total volume of the adhesive composition) and dispersed to obtain an adhesive composition. The obtained adhesive composition was coated onto a 80 µm-thick fluorine resin film with a coating apparatus and dried with hot air at 70°C for 10 minutes to obtain an adhesive film with an adhesive layer thickness of 20 µm.

**[Table 1]**

| | | Example 1 | Example 2 | Example 3 | Example 4 | Example 5 | Example 6 | Comp. Ex.1 | Comp. Ex.2 | Comp. Ex. 3 |
|---|---|---|---|---|---|---|---|---|---|---|
| Thermoplastic resin | Phenoxy resin | 40 | - | 40 | - | - | - | - | - | - |
| | Butyral resin | - | 35 | - | 35 | - | - | 35 | 35 | 35 |
| | Polyester urethane resin | - | - | - | - | 40 | 40 | - | - | - |
| | Urethane resin | 10 | 15 | 10 | 15 | 10 | 10 | 15 | 15 | 15 |
| Radical polymerizing compound | EA-0200 | 50 | 50 | 30 | 25 | 50 | - | - | - | - |
| | EA-0500 | - | - | 20 | 15 | - | 40 | - | - | - |
| | UA | - | - | - | 10 | - | 10 | 50 | - | 30 |
| | FA-324A | - | - | - | - | - | - | - | 50 | 20 |
| Phosphoric acid-containing compound | P-2M | 3 | 3 | 3 | 3 | 3 | 3 | 3 | 3 | 3 |
| Radical polymerization initiator | PERHEXYL O | 3 | 3 | 3 | 3 | 3 | 3 | 3 | 3 | 3 |

| | | | | | | | | | | |
|---|---|---|---|---|---|---|---|---|---|---|
| (Units in parts by mass) | | | | | | | | | | |

### [Measurement of bonding strength and connection resistance]

The adhesive film obtained by the method described above was used to bond together a flexible circuit board (FPC board) having 500 copper circuits with a line width of 25 µm, a pitch of 50 µm and a thickness of 18 µm and a glass board with a 0.2 µm indium oxide (ITO) thin-layer (ITO substrate, thickness: 1.1 mm, surface resistance: 20 Ω/sq.), by heat pressing for 10 seconds at a temperature of 160°C and a pressure of 3 MPa, using a thermocompression bonding apparatus (heating system: constant heating, product of Toray Engineering). This produced a connection structure (circuit member connection structure) comprising the FPC board and ITO substrate connected by the cured adhesive film across a width of 2 mm.

The resistance value between the adjacent circuits of the connection structure was measured using a multimeter immediately after bonding and after holding for 168 hours in a high-temperature, high-humidity vessel at 85°C, 85% RH. The resistance value was expressed as the average of 37 resistance points between the adjacent circuits. The results are shown in Table 2.

The bonding strength of the connection structure was measured by the 90 degree peel method of JIS-Z0237 and evaluated. The bonding strength measuring apparatus used was a TENSILON UTM-4 (peel rate: 50 mm/min, 25°C, product of Toyo Baldwin Co., Ltd.). The bonding strength was also measured immediately after bonding and after holding for 168 hours in a high-temperature, high-humidity vessel at 85°C, 85% RH. The results are shown in Table 2.

**[Table 2]**

| | Connection resistance (Ω) | | Bonding strength (N/m) | |
|---|---|---|---|---|
| | Immediately after bonding | After 168 h | Immediately after bonding | After 168 h |
| Example 1 | 1.5 | 2.8 | 700 | 620 |
| Example 2 | 1.2 | 2.5 | 710 | 680 |
| Example 3 | 1.3 | 2.3 | 680 | 560 |
| Example 4 | 1.3 | 2.4 | 750 | 620 |
| Example 5 | 1.2 | 2.2 | 710 | 650 |
| Example 6 | 1.7 | 2.4 | 680 | 570 |
| Comp. Ex. 1 | 2.6 | 7.8 | 670 | 480 |
| Comp. Ex. 2 | 1.9 | 3.2 | 480 | 330 |
| Comp. Ex. 3 | 2.4 | 6.5 | 520 | 430 |

The adhesive films obtained in Examples 1-6 exhibited satisfactory connection resistance and bonding strength both immediately after bonding and after holding for 168 hours in a high-temperature, high-humidity vessel at 85°C, 85% RH, under the connecting conditions with a heating temperature of 160°C, thus confirming that they have satisfactory properties for a wide range of heating temperatures. In contrast, satisfactory properties were not obtained with the adhesive films of Comparative Examples 1-3 that did not have a radical polymerizing compound with a fluorene structure according to the invention. Specifically, the adhesive film of Comparative Example 1 had high connection resistance after high-temperature, high-humidity treatment, the adhesive film of Comparative Example 2 had low adhesive force immediately after bonding and after high-temperature, high-humidity treatment, and the adhesive film of Comparative Example 3 exhibited an increase in connection resistance and reduction in adhesive force after high-temperature, high-humidity treatment.

### [Evaluation of storage stability]

The adhesive film obtained in Example 1 was allowed to stand in a vacuum package for 3 days at 40°C. The adhesive film was then used to prepare a connection structure (circuit member connection structure) by connecting an FPC board and ITO substrate by thermocompression bonding at 160°C, 3 MPa for 10 seconds across a width of 2 mm, in the same manner as Example 1. The bonding strength and connection resistance immediately after bonding of the connection structure were measured by the same method as Example 1 to be a bonding strength of 710 N/m and a connection resistance of 1.2 Ω, thus confirming excellent storage stability.

Thus, it was confirmed that the invention can provide an adhesive composition that, as a radical curing composition, exhibits excellent bonding strength and maintains stable performance (bonding strength and connection resistance) even after reliability testing (high-temperature, high-humidity testing), as well as an adhesive film and circuit member connection structure employing it.

### Industrial Applicability

As explained above, it is possible according to the invention to provide an adhesive composition that, as a radical curing composition, exhibits excellent bonding strength and maintains stable performance (bonding strength and connection resistance) even after reliability testing (for example, standing at 85°C/85% RH), as well as an adhesive film and circuit member connection structure employing it.

## Claims

1. An adhesive composition comprising
(a) a thermoplastic resin,
(b) a radical polymerizing compound with one or more fluorene structures in the molecule, and
(c) a radical polymerization initiator.

2. An adhesive composition according to claim 1, which further contains (d) a vinyl compound with one or more phosphate groups in the molecule.

3. An adhesive composition according to claim 1 or 2, wherein the (a) thermoplastic resin contains at least one selected from the group consisting of phenoxy resins, polyester resins, polyurethane resins, polyester-urethane resins, butyral resins, acrylic resins and polyimide resins.

4. An adhesive composition according to any one of claims 1 to 3, which further contains (e) conductive particles.

5. A circuit member connection structure comprising
a first circuit member having a first circuit electrode formed on the main side of a first circuit board,
a second circuit member having a second circuit electrode formed on the main side of a second circuit board, and
a circuit-connecting member formed between the main side of the first circuit board and the main side of the second circuit board, which connects the first and second circuit members with the first circuit electrode and second circuit electrode positioned facing each other,
wherein the circuit-connecting member consists of the cured product of an adhesive composition according to any one of claims 1 to 4, and the mutually facing first circuit electrode and second circuit electrode are electrically connected.
